# EUROPÄISCHE PATENTSCHRIFT

(11) **EP 4 000 137 B1**
(45) Veröffentlichungstag und Bekanntmachung des Hinweises auf die Patenterteilung: **03.09.2025**
(21) Anmeldenummer: 20746100.5
(22) Anmeldetag: 10.07.2020
(51) Int. Cl.: H01R 12/58, H01R 12/52, H01R 12/71

(54) **KONTAKTELEMENT ZUM ELEKTRISCHEN VERBINDEN VON LEITERKARTEN UND VERFAHREN ZUR MONTAGE EINER LEITERKARTENANORDNUNG**
CONTACT ELEMENT FOR ELECTRICALLY CONNECTING PRINTED CIRCUIT BOARDS AND METHOD FOR ASSEMBLING A PRINTED CIRCUIT BOARD ARRANGEMENT
ÉLÉMENT DE CONTACT POUR RELIER ÉLECTRIQUEMENT DES CARTES À CIRCUIT IMPRIMÉ ET PROCÉDÉ D'ASSEMBLAGE D'UN ARRANGEMENT DE CARTES À CIRCUIT IMPRIMÉ

(30) Priorität: 19.07.2019 DE 102019119588
(43) Veröffentlichungstag der Anmeldung: 25.05.2022
(73) Patentinhaber: HARTING Electronics GmbH, 32339 Espelkamp (DE)
(72) Erfinder: LINDKAMP, Marc, 32339 Espelkamp (DE); BUSSMANN, Rainer, 32339 Espelkamp (DE)
(86) Internationale Anmeldenummer: PCT/DE2020/100603
(87) Internationale Veröffentlichungsnummer: WO 2021/013297

(56) Entgegenhaltungen:
- WO-A1-2017/048913
- DE-B3- 102008 064 590
- DE-B4- 102016 107 898
- FR-A1- 2 693 340

## Beschreibung

Die Erfindung geht aus von einem Kontaktelement nach dem Oberbegriff des unabhängigen Anspruchs 1.

Ein derartiges Kontaktelement zum Herstellen eines elektrischen Kontakts zwischen einer ersten und einer zweiten Leiterkarte weist einen Befestigungsbereich zum Befestigen des Kontaktelements an der ersten Leiterkarte und einen Steckerabschnitt für eine Steckverbindung zu der zweiten Leiterkarte auf.

Bei einem gattungsgemäßen Verfahren zur Montage einer Leiterkartenanordnung ist vorgesehen, dass ein Befestigungsbereich von mindestens einem Kontaktelement an einer ersten Leiterkarte befestigt wird und dass ein Steckerabschnitt des mindestens einen Kontaktelements mit einer zweiten Leiterkarte verbunden wird. Durch das mindestens eine Kontaktelement wird ein elektrischer Kontakt zwischen der ersten und zweiten Leiterkarte hergestellt.

Die Leiterkarten können insbesondere parallel zueinander angeordnet sein und prinzipiell in weitgehend beliebigen technischen Anwendungen eingesetzt werden. Das Kontaktelement dient dem Übertragen von elektrischen Signalen und / oder elektrischer Energie zwischen den Leiterkarten, das heißt zwischen Schaltungen der beiden Leiterkarten.

Ein beispielhaftes Einsatzgebiet ist bei Fahrzeugen gegeben, wo die Leiterkarten zu verschiedenen Motorkomponenten oder anderen Fahrzeugkomponenten gehören. Insbesondere bei solchen Automobilanwendungen treten Vibrationen und Stöße auf, durch welche das Risiko besteht, dass eine elektrische Kontaktierung zwischen den Leiterkarten kurzzeitig unterbrochen wird oder aufgrund der Vibrationen Beschädigungen drohen. Werden die Leiterkarten mit dem elektrischen Kontaktelement für eine sicherere Kontaktierung unter höheren Druck aneinander gedrückt, könnten sich langfristig die Leiterkarten verbiegen.

### Stand der Technik

Ein Koaxialverbinder zum Bereitstellen einer elektrischen Verbindung zwischen zwei Leiterkarten ist in DE 60 2005 000 768 T2 und in EP 1 157 448 B1 beschrieben. Aus DE 10 2005 030 375 B4 ist ein Steckverbinder bekannt, der an einer ersten Leiterkarte montiert ist und eine Buchse oder elektrische Kontaktbereiche einer zweiten Leiterkarte kontaktiert. DE 101 07 711 A1 nutzt eine flexible gedruckte Schaltung zum Verbinden zweier Leiterkarten. EP 1 929 848 B1 beschreibt eine Verbindung zweier Leiterkarten, die senkrecht zueinander angeordnet sind, wobei eine der Leiterkarte hakenförmige Bereiche aufweist, welche in Löcher der anderen Leiterkarte eingreifen.
Die DE 10 2016 107 898 B4 zeigt einen Leiterplattenverbinder mit einem M-förmig gebogenen Kontaktelement zur elektrischen Verbindung der Leiterplatte,
Die FR 2 693 340 A1 zeigt einen gewinkelten Gabelsteckverbinder zur Kontaktierung zweier Leiterkarten.
Die WO 2017/048913 A1 zeigt eine Vorrichtung zur Verbindung einer bordeigenen Stator-Leiterplatte eines Motors mit mehreren Schaltungen auf einer Controller-Leiterplatte.

Die DE 10 2008 064 590 B3 zeigt eine elektrische Kontaktanordnung zur Verbindung einer polygonalen Buchse mit zwei sich im Wesentlichen in einer Steckrichtung erstreckenden Kontaktarmen,

Sofern bekannte Kontaktelemente eine gegenüber Vibrationen sichere Verbindung zwischen zwei Leiterkarten ermöglichen, wird dies nur durch verhältnismäßig aufwendige und damit kostenintensive Kontaktelemente erreicht.

Das Deutsche Patent- und Markenamt hat in der Prioritätsanmeldung zu vorliegender Anmeldung den folgenden Stand der Technik recherchiert: DE 10 2005 030 375 B4, DE 10 2008 064 590 B3, DE 10 2016 107 898 B4, DE 101 07 711 A1, DE 60 2005 000 768 T2, FR 2 693 340 A1, EP 1 157 448 B1, EP 1 929 848 B1 und WO 2017/ 048 913 A1.

### Aufgabenstellung

Eine Aufgabe der Erfindung besteht darin, ein Kontaktelement und ein Verfahren zur Montage einer Leiterkartenanordnung anzugeben, welche bei einfachem Aufbau eine sichere elektrische Verbindung zwischen zwei Leiterkarten bereitstellen.

Die Aufgabe wird durch das Kontaktelement mit den Merkmalen des unabhängigen Anspruchs 1 gelöst.

Vorteilhafte Ausgestaltungen der Erfindung sind in den Unteransprüchen und der folgenden Beschreibung angegeben.

Bei dem Kontaktelement der oben genannten Art umfasst erfindungsgemäß der Steckerabschnitt mindestens zwei Kontaktarme, welche elektrisch leitfähig miteinander verbunden sind.

Bei dem vorgenannten Verfahren zur Montage, das heißt zum Zusammenbau, einer Leiterkartenanordnung weist erfindungsgemäß die zweite Leiterkarte pro Kontaktelement zumindest eine jeweilige Leiterkartenöffnung auf. Bei jedem Kontaktelement weist der Steckerabschnitt mindestens zwei Kontaktarme auf, welche elektrisch leitfähig miteinander verbunden sind. Die Kontaktarme von jedem Kontaktelement werden durch die jeweilige Leiterkartenöffnung gesteckt, um eine elektrische Verbindung herzustellen.

Durch mehrere Kontaktarme kann auch bei Vibrationen ein elektrischer Kontakt von zumindest einem der Kontaktarme gewährleistet werden. Indem die Kontaktarme elektrisch leitfähig miteinander verbunden sind, können sie das gleiche elektrische Potential haben. Wird das Kontaktelement zur Signalübertragung genutzt, geben die mehreren Kontaktarme nicht verschiedene Informationen oder Spannungsniveaus aus, sondern können sich auf dem im Wesentlichen gleichen elektrischen Potential befinden. Das Kontaktelement kann daher einen Einzelkontakt darstellen.

Das Kontaktelement und somit die Kontaktarme können aus einem metallischen Material bestehen. Hierbei sind die Kontaktarme relativ zueinander biegsam beziehungsweise elastisch oder federnd. Dies ist für eine sichere Kontaktierung bedeutsam, wie im Späteren näher erläutert.

Ein Kontaktarm hat eine längliche Form, welche insbesondere mindestens zweimal oder mindestens dreimal so groß sein kann wie die größte Querschnittsabmessung des Kontaktarms. Die Richtung der länglichen Form wird vorliegend auch als Höhenrichtung oder z-Richtung bezeichnet. Ein elektrischer Kontakt zur zweiten Leiterkarte, das heißt zu einem elektrisch leitfähigen Teil der zweiten Leiterkarte, kann über die gesamte Ausdehnung des Kontaktarms erfolgen. Die längliche Form ermöglicht daher in z-Richtung größere Positionierungstoleranzen der zwei Leiterkarten zueinander. Auch sind Vibrationen in z-Richtung unproblematisch, um einen fortwährenden elektrischen Kontakt zu gewährleisten.

Das Kontaktelement weist drei oder mehr Kontaktarme auf, welche alle elektrisch leitfähig miteinander verbunden sind, so dass sie wiederum das gleiche elektrische Potential haben. Mindestens drei Kontaktarme können vorteilhaft sein, um einen durchgängigen Kontakt von zumindest einem Kontaktarm auch bei weitgehend beliebig wirkenden Kräften quer zur z-Richtung zu gewährleisten. Nähere Details hierzu werden im Späteren näher beschrieben.

Das Kontaktelement kann insbesondere einstückig gebildet sein, das heißt aus einem Einzelteil bestehen und nicht etwa aus mehreren miteinander verbundenen Komponenten. Das Einzelteil selbst oder eine hierauf aufgebrachte Beschichtung ist elektrisch leitfähig. Diese einstückigen Gestaltungen ermöglichen eine kostengünstige Herstellung und Montage. Außerdem wird gewährleistet, dass die mehreren Kontaktarme elektrisch leitend miteinander verbunden sind.

Das Kontaktelement kann eine längliche Form entlang einer Längsachse (x-Richtung) haben, wobei sich die Kontaktarme in eine Höhenrichtung (z-Richtung) senkrecht zur Längsachse erstrecken. Die längliche Form des Kontaktelements in x-Richtung kann so verstanden werden, dass dessen Ausdehnung in x-Richtung wesentlich größer, beispielsweise mindestens dreimal größer, als in einer Querrichtung (y-Richtung) ist, welche senkrecht zur x-Richtung steht. Der erste und der zweite Kontaktarm können an gegenüberliegenden Seiten der Längsachse (x-Achse) hervorstehen; in anderen Worten steht der erste Kontaktarm in der y-Richtung von der Längsachse hervor, und der zweite Kontaktarm steht in entgegengesetzter Richtung von der Längsachse hervor.

Hierdurch können die mindestens zwei Kontaktarme in der Querrichtung in einer zugehörigen Leiterkartenöffnung der zweiten Leiterkarte eingeklemmt werden. Der erste und zweite Kontaktarm werden somit im montierten Zustand in y-Richtung aufeinander zu gedrückt und verformt beziehungsweise gebogen.

Die Kontaktarme können entlang der Längsachse des Kontaktelements (x-Richtung) voneinander beabstandet sein. Hierdurch wird ein Berühren der Kontaktarme auch dann vermieden, wenn die Kontaktarme gebogen werden, beispielsweise durch ein Drücken der Kontaktarme gegen die Wände der Leiterkartenöffnung, durch welche die Kontaktarme hindurchragen. Ebenso können die Kontaktarme zueinander in y-Richtung beabstandet sein, so dass auch ein Verbiegen in y-Richtung ermöglicht wird.

Das Kontaktelement weist mindestend einen dritten Kontaktarm auf. Entlang der Längsachse des Kontaktelements (x-Richtung) befindet sich bei dieser Benennung der zweite Kontaktarm zwischen dem ersten und dritten Kontaktarm. Der erste und dritte Kontaktarm stehen nun beide in der Querrichtung (y) von der Längsachse hervor, wohingegen der zweite Kontaktarm in entgegengesetzter Richtung (-y) von der Längsachse hervorsteht. Im montierten Zustand, in welchem die Kontaktarme in eine Leiterkartenöffnung hineinragen, berühren somit der erste und dritte Kontaktarm dieselbe Seite der Leiterkartenöffnung, während der zweite Kontaktarm die gegenüberliegende Seite der Leiterkartenöffnung berührt. Hierdurch wird vermieden, dass sich das Kontaktelement relativ zur Leiterkartenöffnung drehen und dadurch den elektrischen Kontakt verlieren könnte.

Die Kontaktarme können in ihrem Querschnitt, das heißt in der xy-Ebene, eine gebogene Form haben, beispielsweise eine Ringabschnittsform. Insbesondere können die Kontaktarme im Querschnitt in die Richtung gebogen sein, in welcher sie von der Längsachse des Kontaktelements hervorstehen. Im montierten Zustand berührt dadurch ein Kontaktarm in der Regel mit seinem mittigen Bereich eine Wand der Leiterkartenöffnung. Ein elektrischer Kontakt ist hierdurch sichererer als in dem Fall, dass ein Kontakt nur an einer Kante des Kontaktarms vorläge.

Als Einführhilfe beim Einstecken der Kontaktarme in eine Leiterkartenöffnung können die Kontaktarme eine sich verjüngende Form haben. Die Abmessungen der Kontaktarme, insbesondere in y-Richtung, werden also kleiner mit größer werdendem Abstand vom Befestigungsbereich, an welchem das Kontaktelement mit einer ersten Leiterkarte verbunden wird. Zumindest die beiden Kontaktarme, die in x-Richtung am weitesten außen liegen, können zudem einen in x-Richtung schrägen oder sich verjüngenden Bereich als Einführhilfe aufweisen. Der erste Kontaktarm ist also an seiner Seite, welche dem zweiten Kontaktarm abgewandt ist, angeschrägt. Im Fall von drei Kontaktarmen ist ebenso der dritte Kontaktarm an seiner Seite, welche dem zweiten Kontaktarm abgewandt ist, angeschrägt. Durch die Anschrägung oder Verjüngung kann auch eine größere Toleranz gegenüber Positionierungenauigkeiten zwischen dem Kontaktelement und der zugehörigen Leiterkartenöffnung erreicht wird. Insbesondere bei später näher beschriebenen Ausführungen, welche zusätzliche Mittel als Einführhilfe umfassen, kann durch die verjüngende Form auch allein eine vergrößerte Toleranz gegenüber Positionierungenauigkeiten erreicht werden, ohne dass diese Form als Einführhilfe dient.

Der Befestigungsbereich kann allgemein ein oder mehrere Vorsprünge, Haken oder andere Geometrien umfassen, welche für eine Press-, Klemm- oder Lötverbindung mit der ersten Leiterkarte oder Komponenten an der ersten Leiterkarte geeignet sind. Insbesondere kann der Befestigungsbereich mindestens zwei Befestigungsfüße zum Befestigen des Kontaktelements an der ersten Leiterkarte aufweisen. Die Befestigungsfüße können in entsprechende Ausnehmungen der ersten Leiterkarte eingesteckt werden und dort insbesondere durch eine Presspassung gehalten und/oder verlötet sein. Die Befestigungsfüße ragen also in der Höhenrichtung/ z-Richtung in entgegengesetzter Richtung zu den Kontaktarmen hervor.

In Richtung der Längsachse/ x-Richtung können sämtliche Kontaktarme zwischen den zwei Befestigungsfüßen angeordnet sein. Außerdem können sich die Befestigungsfüße in Querrichtung (y-Richtung) weiter von der Längsachse entfernt befinden als eine Ausdehnung der Kontaktarme in der Querrichtung groß ist. Durch diese Anordnung wird die Stabilität des Kontaktelements auf der ersten Leiterkarte erhöht. Insbesondere wird ein Kippen des Kontaktelements vor Abschluss eines Anlötens an die erste Leiterkarte vermieden. Um ein korrektes Einführen der Befestigungsfüße in die zugehörigen Ausnehmungen der ersten Leiterkarte zu gewährleisten, können die Befestigungsfüße jeweils Anlageflächen aufweisen, welche auf der ersten Leiterkarte aufliegen.

Die vorliegende Erfindung betrifft auch eine Kontaktiervorrichtung mit mehreren Kontaktelementen, die jeweils wie in dieser Offenbarung geschrieben gebildet sind. Die Kontaktelemente können identisch zueinander gebildet sein, oder auch gemäß verschiedenen hier beschriebenen Ausführungsformen. Die Kontaktiervorrichtung umfasst außerdem einen Isolierkörper, in dem für jedes Kontaktelement jeweils mindestens eine Befestigungsöffnung gebildet ist, in welche das jeweilige Kontaktelement hineinragt. Die Befestigungsöffnung kann insbesondere eine Schlitzform haben und durch eine Presspassung das jeweilige Kontaktelement halten. Der Isolierkörper ist aus einem elektrisch isolierenden Material und hält die Kontaktelemente beabstandet zueinander. Die Kontaktarme der verschiedenen Kontaktelemente ragen jeweils von einer Oberseite des Isolierkörpers heraus. Die Befestigungsfüße der Kontaktelemente ragen von einer Unterseite des Isolierkörpers heraus. Der Isolierkörper kann auf die erste Leiterkarte aufgesetzt werden und optional durch eine Presspassung an der ersten Leiterkarte gehalten werden. Beim Aufsetzen des Isolierkörpers werden auch die an seiner Unterseite hervorstehenden Befestigungsfüße in die entsprechenden Ausnehmungen in der ersten Leiterkarte eingesetzt.

Durch den Isolierkörper können in einem ersten Montageschritt alle Kontaktelemente am Isolierkörper angebracht werden, so dass anschließend in einem einzigen Arbeitsschritt der Isolierkörper mit allen Kontaktelementen an der ersten Leiterkarte montiert werden kann. Diese Trennung der Montageschritte kann wichtig sein, um die Anforderungen beim Zusammenbau der ersten Leiterkarte möglichst gering zu halten. Hierbei kann der Isolierkörper mit den Kontaktelementen im vormontierten Zustand geliefert werden, so dass ein Käufer ohne spezielles Werkzeug oder besonderen Aufwand den vormontierten Isolierkörper mit den Kontaktelementen auf einer Leiterkarte befestigen kann.

Der Isolierkörper kann einstückig gebildet sein, womit die Herstellung erleichtert ist. An seiner Oberseite kann er mindestens zwei emporragende Justierstifte aufweisen, welche länger als die Kontaktarme sind. Zudem können die Justierstifte jeweils ein sich verjüngendes Ende haben. In der zweiten Leiterkarte können entsprechende Justierlöcher zum Aufnehmen der Justierstifte vorhanden sein. Beim Zusammenbau werden die Justierstifte zunächst in die Justierlöcher eingeführt und erst danach kommen die Kontaktarme mit der zweiten Leiterkarte in Berührung.

Die Erfindung betrifft auch eine Leiterkartenanordnung mit mindestens einem erfindungsgemäßen Kontaktelement oder mindestens einer erfindungsgemäßen Kontaktiervorrichtung. Die Leiterkartenanordnung weist zudem eine erste Leiterkarte auf, an welcher das mindestens eine Kontaktelement, insbesondere alle Kontaktelemente, befestigt sind, also beispielsweise eingepresst und/oder angelötet sind. Außerdem weist die Leiterkartenanordnung eine zweite Leiterkarte auf, welche insbesondere parallel zur ersten Leiterkarte angeordnet sein kann oder in einem Neigungswinkel von höchstens 45° zur ersten Leiterkarte stehen kann. Die zweite Leiterkarte weist mindestens eine Leiterkartenöffnung zum Einstecken der Kontaktarme des mindestens einen Kontaktelements auf. Prinzipiell können auch mehrere Leiterkartenöffnungen für die verschiedenen Kontaktarme desselben Kontaktelements vorgesehen sein, wobei es aber für eine stabile und kosteneffiziente Herstellung bevorzugt sein kann, wenn alle Kontaktarme eines Kontaktelements in dieselbe Leiterkartenöffnung hinein oder hindurch ragen. Die zweite Leiterkarte kann demnach pro Kontaktelement eine jeweilige Leiterkartenöffnung umfassen.

Eine Leiterkartenöffnung kann durch ein metallisch beschichtetes Loch in der zweiten Leiterkarte gebildet sein. Ist in der vorliegenden Offenbarung davon die Rede, dass ein Kontaktarm die zweite Leiterkarte, die Leiterkartenöffnung oder eine Wand der Leiterkartenöffnung berührt, kann dies so verstanden werden, dass die metallische Beschichtung berührt wird, um einen elektrischen Kontakt bereitzustellen. Die Beschichtungsdicke kann im µm-Bereich liegen, womit eine kostengünstige Herstellung ermöglicht wird. Im Gegensatz zu manchen herkömmlichen Ausführungen werden die Kontaktarme nicht mit Federn oder in anderer Weise unter höherem Druck gegen die zweite Leiterkarte gedrückt, womit ein erhöhter Verschleiß an den elektrischen Kontaktflächen der zweiten Leiterkarte einherginge. Daher kann bei der Erfindung bereits eine dünne Beschichtung im µm-Bereich genügen.

Eine Beschichtung ist insbesondere bei einer geringen Anzahl an Steckvorgängen geeignet, beispielsweise, wenn allein ein einmaliger Zusammenbau vorgesehen ist. Um eine höhere Robustheit gegenüber Verschleiß während des Steckvorgangs bereitzustellen, kann statt eines beschichteten Lochs in der zweiten Leiterkarte auch eine Kontaktbuchse auf der zweiten Leiterkarte angebracht sein. Die Kontaktbuchse ist aus einem elektrisch leitfähigen Material und kann mit beispielsweise Haltevorsprüngen in entsprechende Löcher neben der Leiterkartenöffnung eingedrückt sein.

Die Kontaktbuchse kann mit der zugehörigen Leiterkartenöffnung ausgerichtet sein, so dass ihre Öffnung vollständig mit der Leiterkartenöffnung überlagert. Dabei kann eine Öffnung oder Öffnungsbreite der Kontaktbuchse kleiner sein als die zugehörige Leiterkartenöffnung. Hierdurch wird sichergestellt, dass die Kontaktarme die Kontaktbuchse und nicht etwa das Leiterkartensubstrat oder den Lack neben der Leiterkartenöffnung berühren. Zweckmäßigerweise sind die Kontaktbuchsen auf der Seite der zweiten Leiterkarte angeordnet, welche der ersten Leiterkarte zugewandt ist.

Werden Kontaktbuchsen verwendet, so können die Beschreibungen, dass ein Kontaktelement die zweite Leiterkarte oder deren Leiterkartenöffnung kontaktiert, dahingehend verstanden werden, dass die zur Leiterkartenöffnung gehörende Kontaktbuchse berührt wird. In abgewandelten Ausführungen können die Kontaktarme auch allein in die Kontaktbuchse hineinragen, ohne dass zusätzliche Löcher in der zweiten Leiterkarte vorgesehen sein müssten, in welche die Kontaktarme hinein oder hindurch ragen.

Die Leiterkartenöffnung beziehungsweise die Kontaktbuchse können eine Schlitzform haben oder ein Langloch bilden, dessen Längsrichtung mit der Längsrichtung des zugehörigen Kontaktelements übereinstimmt. Der erste und zweite Kontaktarm berühren hierbei im montierten Zustand gegenüberliegende Seiten der schlitzförmigen Leiterkartenöffnung.

Eine Breite der schlitzförmigen Leiterkartenöffnung kann kleiner sein als eine durch die Kontaktarme definierte Breite des Kontaktelements im nicht montierten Zustand. Im montierten Zustand werden dadurch die Kontaktarme von der schlitzförmigen Leiterkartenöffnung gebogen. Insbesondere werden somit der erste und zweite Kontaktarm in der Querrichtung (also senkrecht zur Längsrichtung der schlitzförmigen Leiterkartenöffnung) aufeinander zu gedrückt, oder in anderen Worten zur Längsachse des Kontaktelements hin gebogen. Hierdurch wird ein sicherer Kontakt zwischen den Kontaktarmen und der Leiterkartenöffnung beziehungsweise der zugehörigen Kontaktbuchse gewährleistet.

Jedes Kontaktelement kann mindestens ein Standbein aufweisen, welches im montierten Zustand auf der ersten Leiterkarte steht.

Das mindestens eine Standbein steht in Richtung der ersten Leiterkarte weiter hervor als die Kontaktarme, so dass unter den Kontaktarmen eine Lücke zur ersten Leiterkarte gebildet wird. Die Lücke vermeidet ein potentiell nachteiliges Kontaktieren der ersten Leiterkarte auch dann, wenn die Kontaktarme durch den Kontakt an der zweiten Leiterkarte gebogen oder verformt werden. Insbesondere kann vorgesehen sein, dass im montierten Zustand allein das mindestens eine Standbein und optional Anlageflächen der Befestigungsfüße auf der ersten Leiterkarte aufstehen, während übrige Bereiche des Kontaktelements, insbesondere die Kontaktarme, beabstandet von der ersten Leiterkarte sind. Das mindestens eine Standbein kann auch zum Positionieren der Befestigungsfüße in z-Richtung relativ zur ersten Leiterkarte dienen. Dabei stehen die Befestigungsfüße weiter hervor als das mindestens eine Standbein.

Die erste Leiterkarte kann elektrisch mit den Befestigungsfüßen verbunden sein. Hingegen kann die erste Leiterkarte in Bereichen, in welchen sie mit dem mindestens einen Standbein in Berührung kommt, elektrisch isoliert sein, so dass hier kein elektrischer Kontakt erzeugt wird.

Jedes Kontaktelement kann zwischen jeweils benachbarten Kontaktarmen je ein Standbein aufweisen. Im Fall von drei Kontaktarmen können somit zwei Standbeine vorgesehen sein, wobei in der xy-Ebene betrachtet ein Standbein zwischen dem ersten und zweiten Kontaktarm und das andere Standbein zwischen dem zweiten und dritten Kontaktarm angeordnet ist. Diese örtliche Nähe zu den Kontaktarmen ist bedeutsam, um bei einem Verbiegen der Kontaktarme einen ungewollten Kontakt zwischen den Kontaktarmen und der ersten Leiterkarte zu vermeiden.

Durch den bestimmungsgemäßen Gebrauch der beschriebenen Ausführungsformen der Erfindung ergeben sich Varianten des erfindungsgemäßen Verfahrens.

### Ausführungsbeispiele

Ausführungsbeispiele der Erfindung sind in den Zeichnungen dargestellt und werden im Folgenden näher erläutert. Es zeigen:
- Fig. 1: eine Perspektivdarstellung eines Ausschnitts einer Leiterkartenanordnung gemäß einem erfindungsgemäßen Ausführungsbeispiel;
- Fig. 2: eine Perspektivdarstellung eines Ausschnitts der Leiterkartenanordnung aus Fig. 1 in einem montierten Zustand;
- Fig. 3: eine Perspektivdarstellung des Kontaktelements der Leiterkartenanordnung aus Fig. 1;
- Fig. 4: eine Aufsicht des Kontaktelements aus Fig. 3;
- Fig. 5: eine Perspektivdarstellung von Komponenten der Leiterkartenanordnung aus Fig. 1 in einem nicht montierten Zustand;
- Fig. 6: eine Perspektivdarstellung von Komponenten der Leiterkartenanordnung aus Fig. 1 in einem teilweise montierten Zustand;
- Fig. 7: eine Perspektivdarstellung der Leiterkartenanordnung aus Fig. 1 in einem teilweise montierten Zustand;
- Fig. 8: eine Perspektivdarstellung der Leiterkartenanordnung aus Fig. 7 in einem montierten Zustand;
- Fig. 9: eine perspektivische Aufsicht einer Kontaktiervorrichtung gemäß einem erfindungsgemäßen Ausführungsbeispiel;
- Fig. 10: eine Perspektivdarstellung der Unterseite der Kontaktiervorrichtung aus Fig. 9;
- Fig. 11: eine Perspektivdarstellung einer Leiterkartenanordnung gemäß einem erfindungsgemäßen Ausführungsbeispiel, umfassend die Kontaktiervorrichtung aus Fig. 9, in einem teilweise montierten Zustand;
- Fig. 12: eine Perspektivdarstellung der Leiterkartenanordnung aus Fig. 11 während des Zusammenbaus;
- Fig. 13: eine Perspektivdarstellung der Leiterkartenanordnung aus Fig. 11 in einem montierten Zustand;
- Fig. 14: eine Aufsicht der Leiterkartenanordnung aus Fig. 13;
- Fig. 15: eine Perspektivdarstellung einer zweiten Leiterkarte einer Leiterkartenanordnung gemäß einem weiteren erfindungsgemäßen Ausführungsbeispiel;
- Fig. 16: eine Perspektivdarstellung von Komponenten der Leiterkartenanordnung aus Fig. 15 in einem nicht montierten Zustand;
- Fig. 17: eine Perspektivdarstellung der Leiterkartenanordnung aus Fig. 15 in einem teilweise montierten Zustand und
- Fig. 18: eine Perspektivdarstellung der Leiterkartenanordnung aus Fig. 17 in einem montierten Zustand.

Die Figuren enthalten teilweise vereinfachte, schematische Darstellungen. Gleiche Elemente sind in der Regel mit übereinstimmenden Bezugszeichen gekennzeichnet.

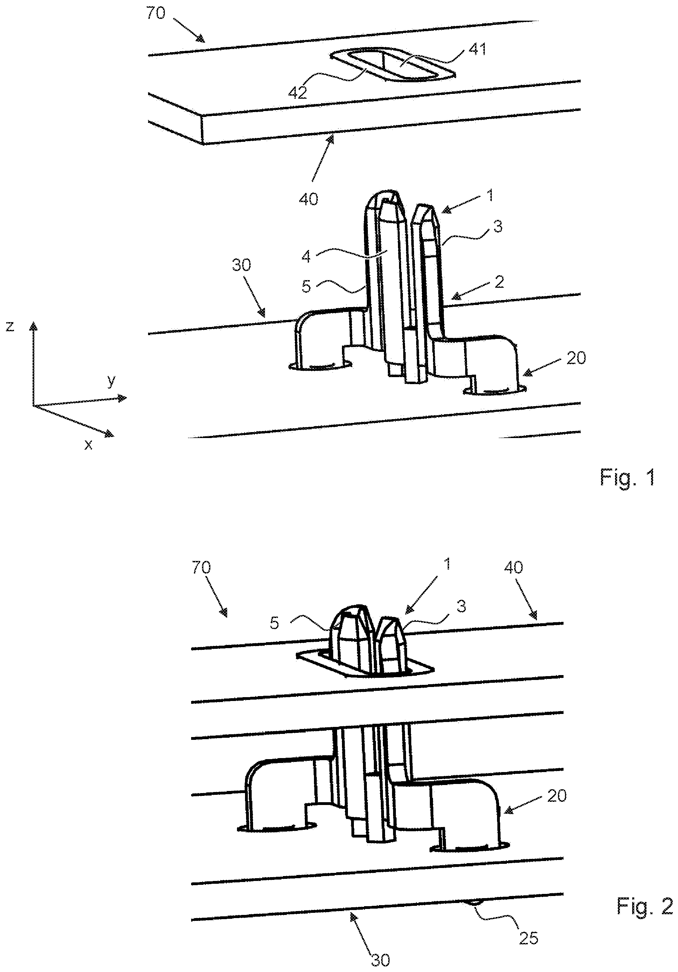

Ein erstes Ausführungsbeispiel einer Leiterplattenanordnung 70 gemäß der Erfindung wird mit Bezug auf die Figuren 1 und 2 beschrieben. Die Leiterplattenanordnung 70 weist eine erste Leiterplatte 30 und eine zweite Leiterplatte 40 sowie ein Kontaktelement 1 zum elektrischen Verbinden der beiden Leiterplatten 30 und 40 auf. Fig. 1 zeigt einen teilweise montierten Zustand, in dem das Kontaktelement 1 an der Leiterplatte 30 befestigt ist, aber noch von der zweiten Leiterplatte 40 beabstandet ist. Fig. 2 zeigt hingegen den fertig montierten Zustand, in welchem das Kontaktelement 1 die zweite Leiterplatte 40 kontaktiert und eine elektrische Verbindung herstellt.

Die beiden Leiterplatten 30 und 40 sind im dargestellten Beispiel parallel zueinander angeordnet, können allgemeiner aber auch in einem Winkel von beispielsweise bis zu 30° zueinander angeordnet sein. Die Leiterplatten 30 und 40 können Bestandteile prinzipiell beliebiger elektronischer Geräte sein und beispielsweise zu verschiedenen Motorkomponenten eines Fahrzeugs gehören. Über den mindestens einen elektrischen Kontakt 1 soll eine Signalübertragung und/oder Energieversorgung erfolgen.

Das Kontaktelement 1 hat einen Befestigungsbereich 20, über den das Kontaktelement 1 an der ersten Leiterkarte 30 befestigt ist. Ein Steckerabschnitt 2 des Kontaktelements 1 dient der elektrischen Kontaktierung der zweiten Leiterkarte 40, das heißt von elektrisch leitfähigen Bereichen oder Komponenten der zweiten Leiterkarte 40. Der Steckerbereich 2 ist durch mehrere längliche Kontaktarme 3 bis 5 gebildet. Im montierten Zustand erstrecken sich die Kontaktarme 3 bis 5 in z-Richtung, welche vorliegend auch als Höhenrichtung bezeichnet wird. Die erste Leiterplatte 30 beziehungsweise ihre Oberfläche erstreckt sich in der xy-Ebene, so dass die Kontaktarme 3 bis 5 senkrecht auf die erste Leiterplatte 30 stehen, oder allgemeiner ausgedrückt in einem Winkel von höchstens 10° zur Flächennormalen der ersten Leiterplatte 30.

Die zweite Leiterkarte 40 weist mindestens eine Leiterkartenöffnung 41 auf. Im dargestellten Beispiel handelt es sich hierbei um ein Langloch in der zweiten Leiterkarte 40, welches mit einer elektrisch leitfähigen Beschichtung 42 versehen ist. Im montierten Zustand von Fig. 2 erstrecken sich die Kontaktarme 3 bis 5 durch die Leiterkartenöffnung 41 und berühren die Beschichtung 42. Ein elektrischer Kontakt wird also an den Seitenflächen der Kontaktarme 3 bis 5 und nicht etwa an der Spitze oder Stirnfläche der Kontaktarme 3 bis 5 erzeugt.

Wie aus Fig. 2 ersichtlich, bietet dieser Aufbau in der z-Richtung große Toleranzen und Robustheit gegenüber Schwingungen. Eine in z-Richtung ungenaue Anordnung der beiden Leiterkarten 30 und 40 zueinander hat aufgrund der Länge der Kontaktarme 3 bis 5 keine Auswirkung auf den elektrischen Kontakt. Bei Schwingungen oder anderen Störeinflüssen in z-Richtung droht kein Kontaktverlust. Dabei wird zwischen den beiden Leiterkarten 30 und 40 keine Spannung in z-Richtung aufgebaut, um die elektrische Kontaktierung zu gewährleisten. Dies steht im Gegensatz zu manchen herkömmlichen Gestaltungen, bei denen ein Kontaktelement zwischen zwei Leiterplatten eingeklemmt wird und das Kontaktelement beispielsweise die Unterseite der zweiten Leiterplatte kontaktiert, welche der ersten Leiterplatte zugewandt ist.

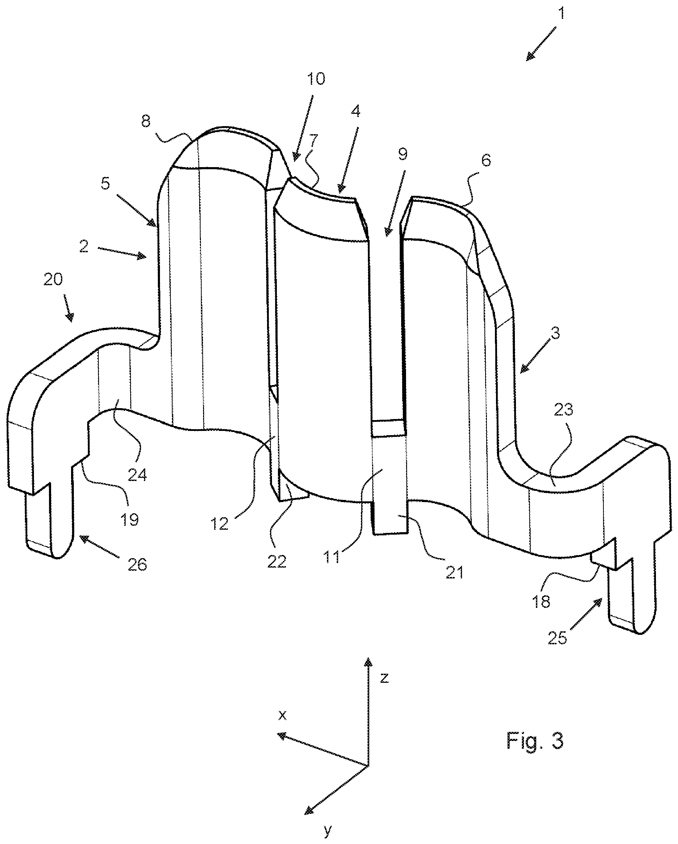

Das Kontaktelement 1 aus den Figuren 1 und 2 ist vergrößert in Fig. 3 gezeigt. Es ist einstückig gebildet, wobei prinzipiell aber auch mehrteilige Ausführungen möglich wären. Die Kontaktarme 3 bis 5 sind elektrisch leitfähig miteinander verbunden und haben im Betrieb das gleiche elektrische Potential. Dadurch wirken die mehreren Kontaktarme 3 bis 5 elektrisch als ein Einzelkontakt. Für eine sichere Kontaktierung zur zweiten Leiterkarte sind die Kontaktarme 3 bis 5 relativ zueinander biegsam oder federnd. Dies wird erreicht, indem ein Verbindungsbereich 11 zwischen dem ersten und zweiten Kontaktarm 3, 4 sowie ein Verbindungsbereich 12 zwischen dem zweiten und dritten Kontaktarm 4, 5 klein im Vergleich zur Länge der Kontaktarme 3 bis 5 ist. Beispielsweise kann eine z-Ausdehnung der Verbindungsbereiche 11 und 12 höchstens 40% oder höchstens 30% der z-Ausdehnung der Kontaktarme 3-5 betragen.

Die Kontaktarme 3 bis 5 sind in x-Richtung versetzt oder hintereinander angeordnet, wodurch das Kontaktelement 1 eine längliche Form in x-Richtung hat, welche vorliegend auch als Längsachse des Kontaktelements 1 bezeichnet wird. Der Befestigungsbereich 20 zum Anbringen an der ersten Leiterkarte wird durch mehrere Befestigungsfüße 25 und 26 gebildet. Im dargestellten Beispiel sind zwei Befestigungsfüße 25 und 26 vorhanden, welche sich in entgegengesetzter Richtung (-z) zu den Kontaktarmen 3 bis 5 erstrecken, also entgegengesetzt zur z-Achse. Von den Kontaktarmen 3 bis 5 führt ein jeweils gebogener oder abgewinkelter Bereich 23, 24 zum jeweiligen Befestigungsfuß 25, 26. Dadurch liegen die Kontaktfüße 25 und 26 in y-Richtung weiter außen, also in y-Richtung weiter von den Kontaktarmen 3 bis 5 entfernt. Diese Anordnung ist bedeutsam, um einen sicheren Stand des Kontaktelements 1 auf der ersten Leiterkarte zu gewährleisten. Dabei befinden sich die Kontaktfüße 25 und 26 auf gegenüberliegenden Seiten zur Längs- oder x-Achse.

Das Kontaktelement 1 umfasst weiterhin Anlageflächen 18 und 19 an den Kontaktfüßen 25 und 26. Die Anlageflächen 18 und 19 werden auf die Oberseite der ersten Leiterkarte aufgesetzt und definieren so, wie weit die Kontaktfüße 25 und 26 in entsprechende Ausnehmungen der ersten Leiterkarte hinein beziehungsweise hindurch ragen.

Zudem weist das Kontaktelement 1 mehrere Standbeine 21, 22 auf, welche ebenfalls auf der Oberseite der ersten Leiterkarte aufgesetzt werden. Durch die Standbeine 21 und 22 wird sichergestellt, dass die Kontaktarme 3 bis 5 beabstandet von der Oberfläche der ersten Leiterkarte sind. Dies wird besonders sicher erreicht, indem das Standbein 21 zwischen dem ersten und zweiten Kontaktarm 3, 4 angeordnet ist und das Standbein 22 zwischen dem zweiten und dritten Kontaktarm 4, 5 angeordnet ist, bei Betrachtung in der xy-Ebene.

Die Kontaktarme 3 bis 5 haben jeweils eine sich zu ihrem steckseitigen Ende hin verjüngenden Bereich 6 bis 8. Dadurch kann ein Einführen in die zugehörige Leiterkartenöffnung der zweiten Leiterkarte erleichtert werden.

Zudem wird hierdurch die erlaubte Toleranz gegenüber ungenauen Positionierungen in xy-Richtung der beiden Leiterkarten zueinander erhöht. Insbesondere haben die in x-Richtung äußeren Kontaktarme 3 und 5 jeweils eine angeschrägte Fläche, wodurch sich die Längs- oder x-Ausdehnung der Kontaktarme 3 bis 5 zum steckseitigen Ende hin verjüngt. Dieser angeschrägte Bereich kann bei dem mittleren Kontaktarm 4 (oder allgemeiner bei den mittleren Kontaktarmen) entfallen oder kleiner sein, wodurch für eine hinreichende mechanische Stabilität der mittlere Kontaktarm 4 in x-Richtung kürzer geformt sein kann als die äußeren Kontaktarme 3 und 5.

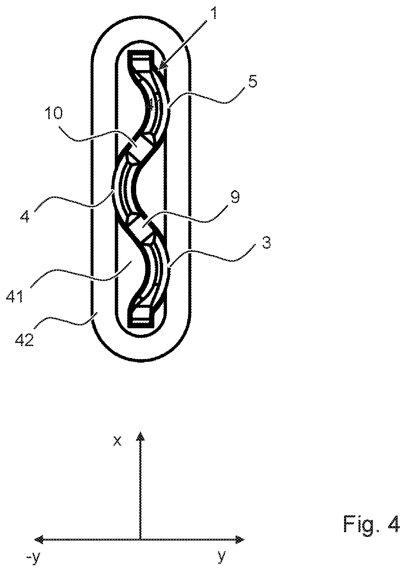

Fig. 4 zeigt eine Aufsicht des Kontaktelements 1, wobei es in eine Leiterkartenöffnung 41 der zweiten Leiterkarte eingesetzt ist. Wie dargestellt, sind die Kontaktarme 3 bis 5 jeweils durch eine Lücke 9 und 10 voneinander beabstandet und berühren die Beschichtung 42 der Leiterkartenöffnung 41. Hierbei ist schematisch veranschaulicht, dass in einem nicht montierten Zustand die y-Ausdehnung der Kontaktarme 3 bis 5 zusammen betrachtet größer ist als die y-Ausdehnung der Leiterkartenöffnung 41. Beim Einführen in die Leiterkartenöffnung 41 werden die Kontaktarme 3 bis 5 daher in y-Richtung zusammen gedrückt. Der erste und dritte Kontaktarm 3 und 5 ragen von einer Längs- oder x-Achse des Kontaktelements 1 in positiver y-Richtung hervor und berühren dadurch eine Schlitzseite der Leiterkartenöffnung 41, während der dazwischenliegende zweite Kontaktarm 4 von der x-Achse des Kontaktelements 1 in negativer y-Richtung hervorragt und dadurch die gegenüberliegende Schlitzseite kontaktiert. Beim Einstecken in die Leiterkartenöffnung 41 werden die Kontaktarme 3 und 5 folglich in negativer y-Richtung gebogen, während der Kontaktarm 4 in positiver y-Richtung verformt wird. Hierdurch wird ein besonders sicherer Kontakt in y-Richtung erreicht, auch wenn Schwingungen oder andere Störkräfte auf die Leiterplattenanordnung wirken. Dabei ist bedeutsam, dass ein hinreichender elektrischer Kontakt auch dann vorliegt, wenn bei Erschütterungen kurzzeitig nur einer der Kontaktarme 3 bis 5 die Beschichtung 42 berührt.

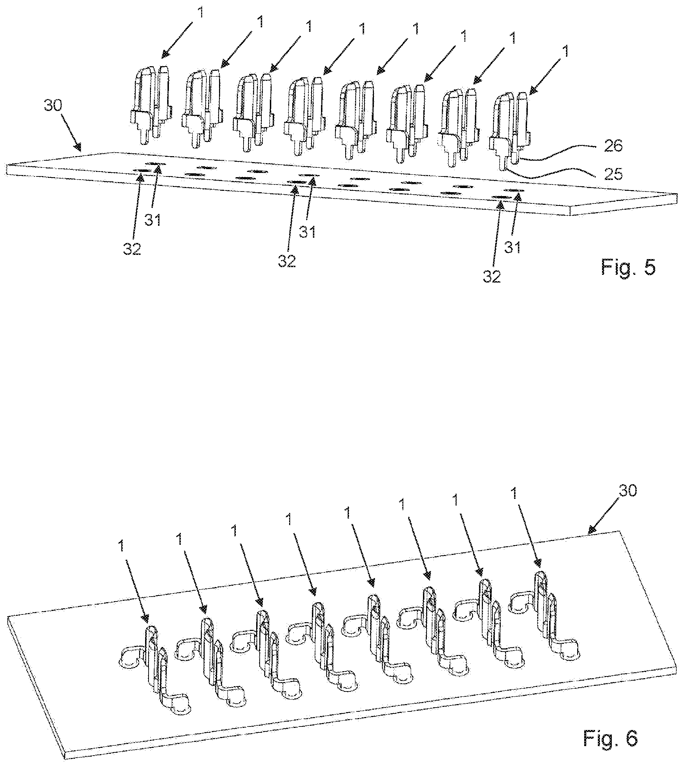

Fig. 5 veranschaulicht die Montage mehrerer Kontaktelemente 1 an der ersten Leiterkarte 30. Die erste Leiterkarte 30 umfasst Ausnehmungen 31 und 32 für die Befestigungsfüße 25, 26 der jeweiligen Kontaktelemente 1. Die Befestigungsfüße 25, 26 werden in die Ausnehmungen 31, 32 eingesetzt und halten dort durch eine Presspassung oder werden dort angelötet. Die Ausnehmungen 31 und 32 können durchgängige Löcher sein. Dies kann zum Anlöten besonders vorteilhaft sein, wozu eine Länge der Befestigungsfüße 25, 26 ab den Anlageflächen 18, 19 (siehe Fig. 1) so bemessen sein kann, dass die Befestigungsfüße 25, 26 durch die erste Leiterkarte 30 vollständig hindurchragen.

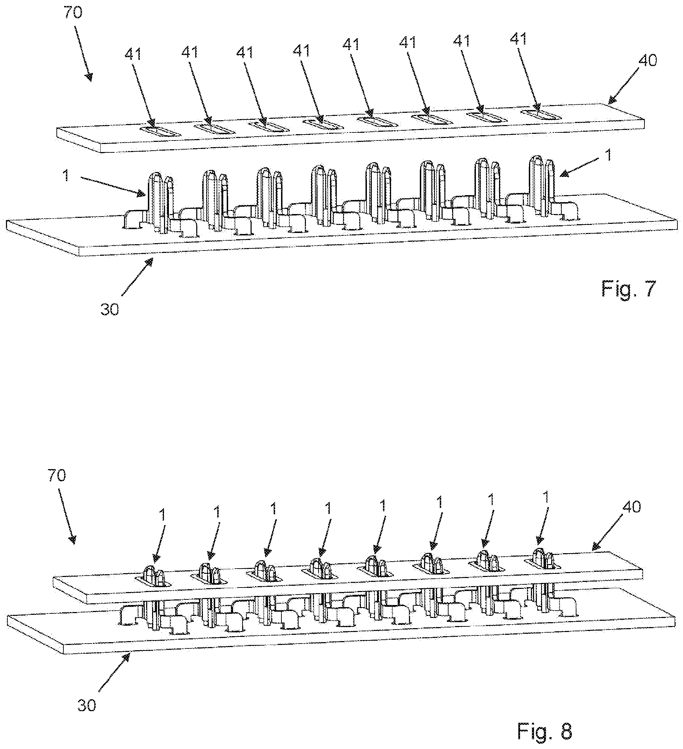

Fig. 6 zeigt in einer perspektivischen Aufsicht einen Zustand, in dem die mehreren Kontaktelement 1 an der ersten Leiterplatte 30 montiert sind. Anschließend erfolgt die Verbindung zur zweiten Leiterkarte 40, wie schematisch in den Figuren 7 und 8 gezeigt. Die zweite Leiterkarte 40 weist pro Kontaktelement 1 jeweils eine Leiterkartenöffnung 41 auf, an welcher ein jeweiliger elektrischer Kontakt hergestellt werden soll. Wie in Fig. 8 dargestellt, ragen die Kontaktarme der Kontaktelemente 1 im fertig montierten Zustand durch die jeweiligen Leiterkartenöffnungen 41 hindurch.

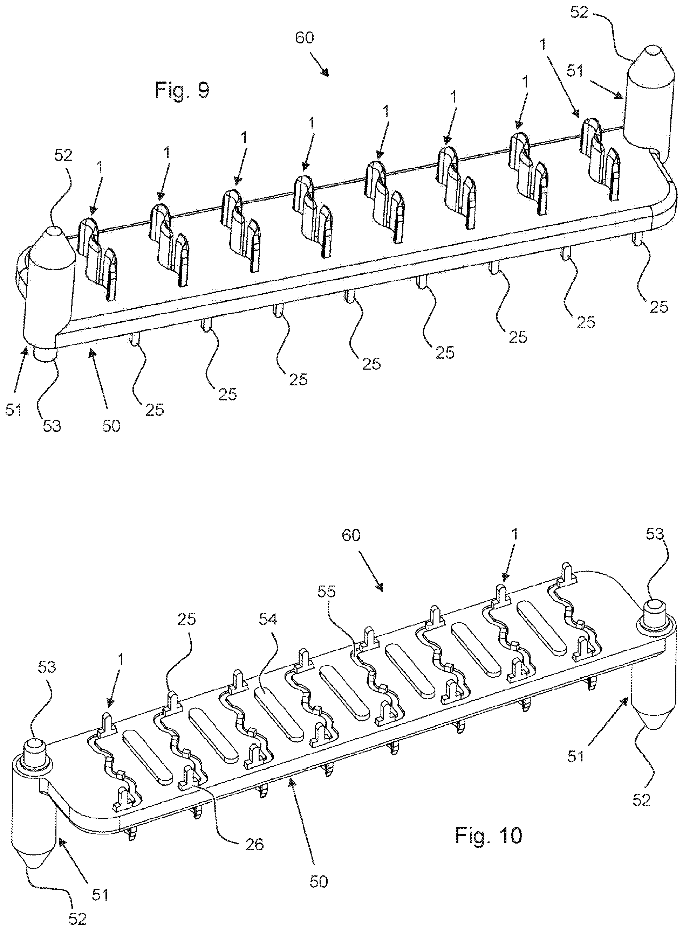

In dem Ausführungsbeispiel der Figuren 6 bis 8 wird jedes Kontaktelement 1 einzeln auf die erste Leiterkarte 30 aufgesetzt und montiert. Um diesen Montageaufwand zu reduzieren, wird bei dem Ausführungsbeispiel der Figuren 9 bis 14 ein zusätzlicher Isolierkörper 50 verwendet, welcher mehrere Kontaktelemente 1 hält. Fig. 9 zeigt den Isolierkörper 50 in einer perspektivischen Aufsicht, während Fig. 10 den Isolierkörper 50 perspektivisch von unten zeigt. Der Isolierkörper 50 hat mehrere Befestigungsöffnungen 55, in welche die Kontaktelemente 1 eingesetzt oder eingeklemmt sind. Die Baugruppe aus Isolierkörper 50 und mehreren Kontaktelementen 1 wird vorliegend als Kontaktiervorrichtung 60 bezeichnet. Die Kontaktiervorrichtung 60 wird als Ganzes auf der ersten Leiterkarte 30 montiert. Hierzu umfasst der Isolierkörper 50 an seiner Unterseite Halteelemente 53 (Fig. 10), welche in entsprechende Ausnehmungen der ersten Leiterkarte 30 eingesteckt oder eingepresst werden. Zudem weist der Isolierkörper 50 an seiner Unterseite mehrere Vorsprünge 54, welche auf der Oberfläche der ersten Leiterkarte 30 aufliegen und so eine präzise z-Lage der Kontaktelemente 1 relativ zur ersten Leiterkarte 30 gewährleisten. Die Befestigungsfüße 25, 26 sowie die in Fig. 3 näher gezeigten Anlageflächen 18, 19 und Standbeine 21, 22 stehen von der Unterseite des Isolierkörpers 50 hervor, so dass sie die erste Leiterkarte 30 berühren können, wenn der Isolierkörper 50 auf die erste Leiterkarte 30 aufgesetzt ist.

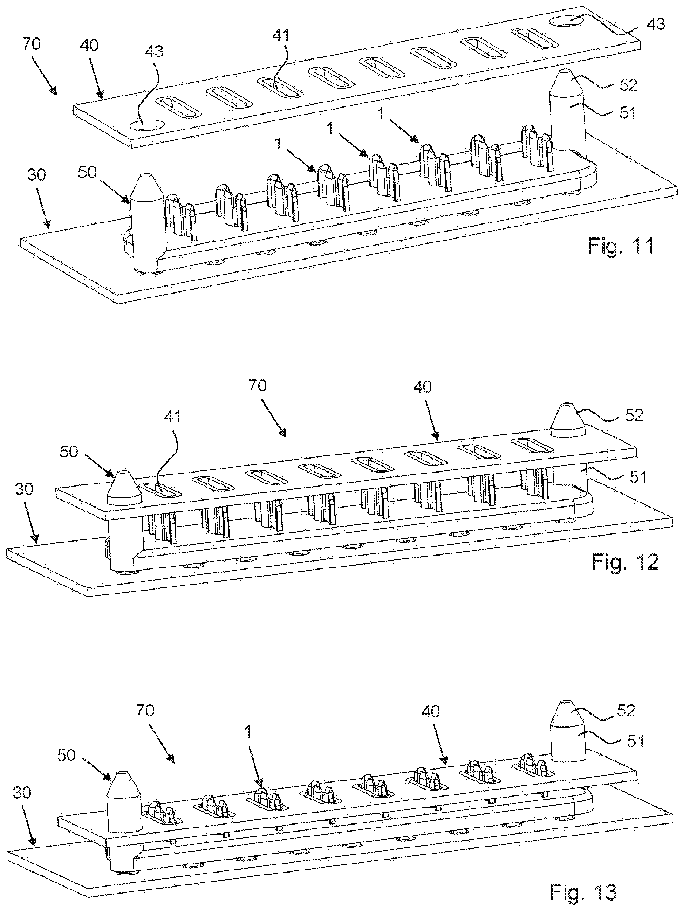

Die Figuren 11 bis 13 veranschaulichen den Montagevorgang der Leiterkartenanordnung 70. In Fig. 11 ist der Isolierkörper 50 bereits mit der ersten Leiterkarte 30 verbunden und weist mehrere Justierstifte 51 auf, welche von der ersten Leiterkarte 30 weiter emporragen als die Kontaktelemente 1. Die Justierstifte 51 werden nun in entsprechende Öffnungen 43 in der zweiten Leiterkarte 40 eingeführt, wie in Fig. 12 gezeigt. Indem die Justierstifte 51 jeweils ein verjüngtes Ende 52 haben, wird eine korrekte xy-Ausrichtung zwischen der zweiten Leiterkarte 40 und dem übrigen Aufbau erleichtert. Die zweite Leiterkarte 40 wird nun weiter auf die erste Leiterkarte 30 zubewegt, bis die Kontaktarme der Kontaktelemente 1 durch die entsprechenden Leiterkartenöffnungen 41 hindurchragen, wie in Fig. 13 dargestellt. Optional können die Justierstifte 51 auch eine Haltegeometrie aufweisen, durch welche eine Bewegung der zweiten Leiterkarte 40 auf die erste Leiterkarte 30 zu begrenzt wird (nicht gezeigt).

Grundsätzlich ist es auch möglich, mehr als zwei Leiterkarten in dieser Weise zu verbinden. So kann eine weitere Leiterkarte, die gleichartig wie die zweite Leiterkarte gebildet ist, auf die Justierstifte aufgesetzt werden (nicht dargestellt). Die Kontaktarme der Kontaktelemente ragen dann durch die Leiterkartenöffnungen von der zweiten und der weiteren Leiterkarte. Eine Informations- oder Energieübertragung kann sodann wahlweise von einer Leiterkarte zu einer oder mehreren anderen Leiterkarten erfolgen.

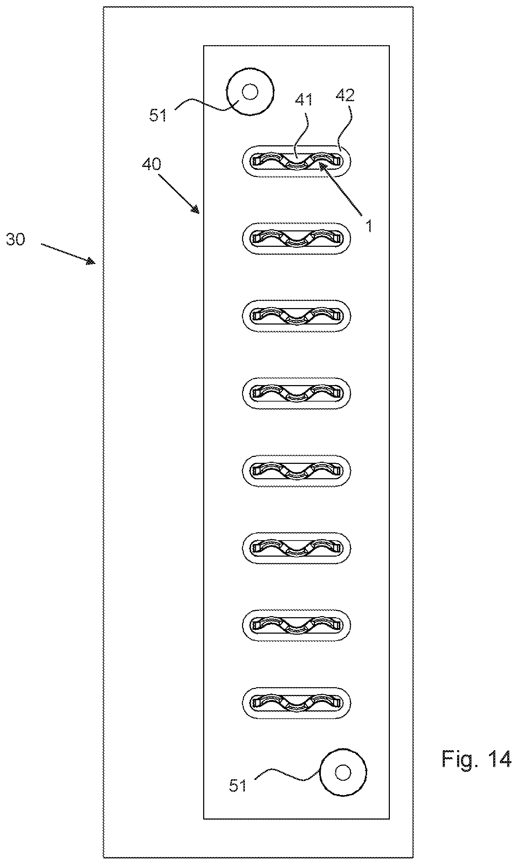

Eine Aufsicht der Leiterkartenanordnung 70 der Fig. 13 ist in Fig. 14 gezeigt. Im dargestellten Beispiel werden mit acht Kontaktelementen 1 acht voneinander unabhängige elektrische Verbindungen zwischen den Leiterkarten 30, 40 bereitgestellt.

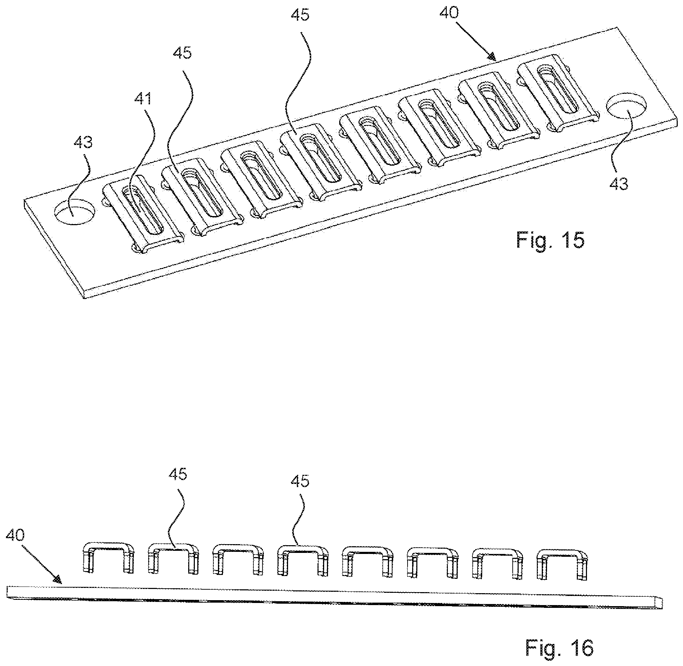

Während bei den bisher beschriebenen Ausführungsbeispielen eine metallische Beschichtung 42 an den Leiterkartenöffnungen 41 vorhanden ist, kann hierauf bei dem Ausführungsbeispiel der Figuren 15 bis 18 verzichtet werden. Fig. 15 zeigt perspektivisch die zweite Leiterkarte 40. Ihre Leiterkartenöffnungen 41 sind hier nicht mit einer leitfähigen Beschichtung versehen, vielmehr ist an jeder Leiterkartenöffnung 41 eine Kontaktbuchse 45 angeordnet. Eine elektrische Verbindung wird dann durch einen Kontakt zwischen den Kontaktarmen eines Kontaktelements und der zugehörigen Kontaktbuchse 45 hergestellt.

Fig. 16 illustriert zunächst die Montage der Kontaktbuchsen 45 an der zweiten Leiterkarte 40. Die Kontaktbuchsen 45 können jeweils Stifte umfassen, welche in entsprechende Halteöffnungen der zweiten Leiterkarte 40 eingesetzt werden, um den Halt der Kontaktbuchsen 45 zu gewährleisten.

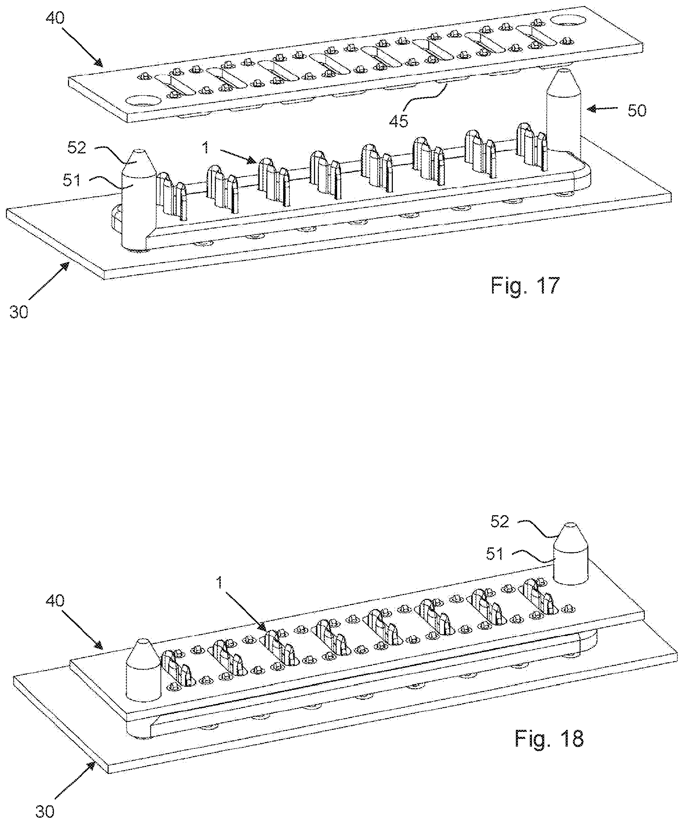

Die erste Leiterplatte 30 mit dem daran montierten Isolierkörper 50 und den Kontaktelementen 1 kann wie bei dem vorherigen Ausführungsbeispiel gebildet sein. Fig. 17 zeigt, dass die Kontaktbuchsen 45 an der Seite der zweien Leiterplatte 40 angeordnet sind, welche der ersten Leiterplatte 30 zugewandt ist. Im montierten Zustand, der in Fig. 18 gezeigt ist, ragen die Kontaktelemente 1 durch die Kontaktbuchsen 45 sowie die Leiterkartenöffnungen 41 hindurch, wobei sie die Kontaktbuchsen 45 und nicht etwa Wände der Leiterkartenöffnung 41 berühren. Durch Kontaktbuchsen 45 kann im Vergleich zu metallischen Beschichtungen eine größere Anzahl an Steckvorgängen ermöglicht werden, ohne dass signifikanter Verschleiß eintritt.

Durch die verschiedenen beschriebenen Ausführungsformen kann ein sicherer elektrischer Kontakt zwischen zumindest zwei Leiterplatten gewährleistet werden, auch wenn Schwingungen oder andere Störkräfte in verschiedenen Richtungen auftreten. Gleichzeitig liegen keine oder kaum Spannungen zwischen den Leiterplatten vor, welche langfristig Verbiegungen oder andere Schäden an den Leiterplatten hervorrufen könnten. Bis auf ein gewisses Zusammendrücken der Kontaktarme in y-Richtung liegen auch an den Kontaktelementen keine oder kaum Spannungen vor, so dass der Verschleiß gering und die Langlebigkeit entsprechend hoch ist.

### Bezugszeichenliste

- 1: Kontaktelement
- 2: Steckerabschnitt
- 3: Erster Kontaktarm
- 4: Zweiter Kontaktarm
- 5: Dritter Kontaktarm
- 6: Verjüngende Form/ verjüngender Bereich des ersten Kontaktarms
- 7: Verjüngende Form/ verjüngender Bereich des zweiten Kontaktarms
- 8: Verjüngende Form/ verjüngender Bereich des dritten Kontaktarms
- 9: Lücke zwischen erstem und zweitem Kontaktarm
- 10: Lücke zwischen zweitem und drittem Kontaktarm
- 11: Verbindungsbereich zwischen dem ersten und zweiten Kontaktarm
- 12: Verbindungsbereich zwischen dem zweiten und dritten Kontaktarm
- 18, 19: Anlageflächen des Kontaktelements zum Stützen auf die erste Leiterkarte
- 20: Befestigungsbereich
- 21, 22: Standbeine des Kontaktelements
- 23, 24: Gebogene Bereiche des Kontaktelements
- 25, 26: Befestigungsfüße des Kontaktelements
- 30: Erste Leiterkarte
- 31, 32: Ausnehmungen in der ersten Leiterkarte zur Aufnahme der Befestigungsfüße
- 40: Zweite Leiterkarte
- 41: Leiterkartenöffnung der zweiten Leiterkarte
- 42: metallische Beschichtung an der Leiterkartenöffnung
- 43: Öffnung in der zweiten Leiterkarte zur Aufnahme eines Justierstifts des Isolierkörpers
- 45: Kontaktbuchse
- 50: Isolierkörper
- 51: Justierstift
- 52: verjüngendes Ende des Justierstifts
- 53: Halteelemente des Isolierkörpers
- 54: Vorsprünge an der Unterseite des Isolierkörpers
- 55: Befestigungsöffnung
- 60: Kontaktiervorrichtung
- 70: Leiterkartenanordnung
- x: Längsachse des Kontaktelements
- y: Querrichtung
- -y: Entgegengesetzte Richtung zur Querrichtung
- z: Höhenrichtung

## Patentansprüche

1. Kontaktelement zum Herstellen eines elektrischen Kontakts zwischen einer ersten und einer zweiten Leiterkarte (30, 40), aufweisend:
einen Befestigungsbereich (20) zum Befestigen an der ersten Leiterkarte (30) und
einen Steckerabschnitt (2) für eine Steckverbindung zu der zweiten Leiterkarte (40),
wobei der Steckerabschnitt (2) mindestens zwei Kontaktarme (3, 4, 5) aufweist, welche elektrisch leitfähig miteinander verbunden sind **dadurch gekennzeichnet, dass**
das Kontaktelement einen dritten Kontaktarm (5) aufweist, wobei sich entlang der Längsachse (x) der zweite Kontaktarm (4) zwischen dem ersten und dritten Kontaktarm (3, 5) befindet, und der erste und dritte Kontaktarm (3, 5) beide in der Querrichtung (y), von der Längsachse (x) hervorstehen, wohingegen der zweite Kontaktarm (4) in der Querrichtung (y) in entgegengesetzter Richtung (-y) von der Längsachse (x) hervorsteht.

2. Kontaktelement nach vorstehendem Anspruch,
**dadurch gekennzeichnet, dass**
alle Kontaktarme (3, 4, 5) elektrisch leitfähig miteinander verbunden sind, so dass sie das gleiche elektrische Potential haben und einen Einzelkontakt bilden.

3. Kontaktelement nach einem der vorstehenden Ansprüche,
**dadurch gekennzeichnet, dass**
das Kontaktelement einstückig gebildet ist.

4. Kontaktelement nach vorstehendem Anspruch,
**dadurch gekennzeichnet, dass**
das Kontaktelement eine längliche Form entlang einer Längsachse (x) hat, wobei sich die Kontaktarme (3, 4, 5) in eine Höhenrichtung (z) senkrecht zur Längsachse (x) erstrecken, und die Querrichtung (y) senkrecht zur Längsachse (x) steht.

5. Kontaktelement nach einem der vorstehenden Ansprüche,
**dadurch gekennzeichnet, dass**
die Kontaktarme (3, 4, 5) entlang der Längsachse (x) voneinander beabstandet sind.

6. Kontaktelement nach einem der vorstehenden Ansprüche,
**dadurch gekennzeichnet, dass**
die Kontaktarme (3, 4, 5) im Querschnitt eine gebogene Form haben.

7. Kontaktelement nach einem der vorstehenden Ansprüche,
**dadurch gekennzeichnet, dass**
die Kontaktarme (3, 4, 5) eine sich verjüngende Form (6, 7, 8) haben.

8. Kontaktelement nach einem der vorstehenden Ansprüche,
**dadurch gekennzeichnet, dass**
der Befestigungsbereich (20) mindestens zwei Befestigungsfüße (25, 26) zum Befestigen an der ersten Leiterkarte (30) aufweist, in Richtung der Längsachse (x) sämtliche Kontaktarme (3, 4, 5) zwischen den Befestigungsfüßen (25, 26) angeordnet sind und sich die Befestigungsfüße (25, 26) in Querrichtung (y) weiter von der Längsachse (x) entfernt befinden als sich die Kontaktarme (3, 4, 5) in der Querrichtung (y) erstrecken.

9. Kontaktiervorrichtung,
**gekennzeichnet durch**
mehrere Kontaktelemente (1), die jeweils nach einem der vorstehenden Ansprüche gebildet sind, und
einen Isolierkörper (50), in dem für jedes Kontaktelement (1) jeweils mindestens eine Befestigungsöffnung (55) gebildet ist, in welchem das jeweilige Kontaktelement (1) gehalten ist,
wobei die Kontaktarme (3, 4, 5) von einer Oberseite des Isolierkörpers (50) hervorragen und Befestigungsfüße (25, 26) der Kontaktelemente (1) von einer Unterseite des Isolierkörpers (50) hervorragen.

10. Kontaktiervorrichtung nach vorstehendem Anspruch,
**dadurch gekennzeichnet, dass**
der Isolierkörper (50) an seiner Oberseite mindestens zwei emporragende Justierstifte (51) aufweist,
die Justierstifte (51) länger als die Kontaktarme (3, 4, 5) sind und die Justierstifte (51) ein sich verjüngendes Ende (52) haben.

11. Leiterkartenanordnung
mit mindestens einem Kontaktelement (1) nach einem der Ansprüche 1 bis 8 oder mit einer Kontaktiervorrichtung nach Anspruch 9 oder 10,
mit einer ersten Leiterkarte (30), an welcher das Kontaktelement (1) oder die Kontaktelemente (1) befestigt sind, und
mit einer zweiten Leiterkarte (40), welche pro Kontaktelement (1) mindestens eine Leiterkartenöffnung (41) zum Einstecken der Kontaktarme (3, 4, 5) des jeweiligen Kontaktelements (1) aufweist.

12. Leiterkartenanordnung nach vorstehendem Anspruch,
**dadurch gekennzeichnet, dass**
an jeder Leiterkartenöffnung (41) eine metallische Beschichtung (42) aufgebracht ist.

13. Leiterkartenanordnung nach Anspruch 11 oder 12,
**dadurch gekennzeichnet, dass**
an jeder Leiterkartenöffnung (41) eine Kontaktbuchse (45) angebracht ist, wobei die Kontaktbuchse (45) eine kleinere Öffnung als die Leiterkartenöffnung (41) hat und die Öffnung der Kontaktbuchse (45) mit der Leiterkartenöffnung (41) ausgerichtet ist.

14. Leiterkartenanordnung nach einem der Ansprüche 11 bis 13,
**dadurch gekennzeichnet, dass**
die Leiterkartenöffnung (41) oder eine zugehörige Kontaktbuchse (45) in Längsrichtung (x) des mindestens einen Kontaktelements (1) eine Schlitzform bildet und
die Kontaktarme (3, 4) gegenüberliegende Schlitzseiten berühren.

15. Leiterkartenanordnung nach vorstehendem Anspruch,
**dadurch gekennzeichnet, dass**
eine Breite der schlitzförmigen Leiterkartenöffnung (41) kleiner ist als eine durch die Kontaktarme (3, 4, 5) definierte Breite des Kontaktelements (1), so dass im montierten Zustand die Kontaktarme (3, 4, 5) von der schlitzförmigen Leiterkartenöffnung (41) gebogen werden.

16. Leiterkartenanordnung nach einem der Ansprüche 11 bis 15,
**dadurch gekennzeichnet, dass**
zum Positionieren von Befestigungsfüßen (25, 26) des Kontaktelements (1) oder der Kontaktelemente (1) relativ zur ersten Leiterkarte (30) jedes Kontaktelement (1) mindestens ein Standbein (21, 22) aufweist, welches im montierten Zustand auf der ersten Leiterkarte (30) steht, und
die Kontaktarme (3, 4, 5) so angeordnet sind, dass sie im montierten Zustand zu der ersten Leiterkarte (30) eine Lücke bilden.

17. Leiterkartenanordnung nach vorstehendem Anspruch,
**dadurch gekennzeichnet, dass**
jedes Kontaktelement (1) zwischen jeweils benachbarten Kontaktarmen (3, 4, 5) je ein Standbein (21, 22) aufweist.

## Claims

1. Contact element for establishing an electrical contact between a first and a second printed circuit board (30, 40), having:
a fastening region (20) for fastening to the first printed circuit board (30) and
a plug portion (2) for a plug connection to the second printed circuit board (40),
wherein the plug portion (2) has at least two contact arms (3, 4, 5), which are connected to one another in an electrically conductive manner, **characterized in that**
the contact element has a third contact arm (5), wherein the second contact arm (4) is located between the first and third contact arms (3, 5) along the longitudinal axis (x), and the first and third contact arms (3, 5) both protrude from the longitudinal axis (x) in the transverse direction (y), whereas, in the transverse direction (y), the second contact arm (4) protrudes from the longitudinal axis (x) in the opposite direction (-y).

2. Contact element according to the preceding claim, **characterized in that**
all contact arms (3, 4, 5) are connected to one another in an electrically conductive manner so that they have the same electrical potential and form an individual contact.

3. Contact element according to one of the preceding claims,
**characterized in that**
the contact element is formed in one piece.

4. Contact element according to the preceding claim, **characterized in that**
the contact element has an elongated form along a longitudinal axis (x), wherein the contact arms (3, 4, 5) extend in a vertical direction (z) perpendicularly to the longitudinal axis (x), and the transverse direction (y) is perpendicular to the longitudinal axis (x).

5. Contact element according to one of the preceding claims,
**characterized in that**
the contact arms (3, 4, 5) are spaced from one another along the longitudinal axis (x).

6. Contact element according to one of the preceding claims,
**characterized in that**
the contact arms (3, 4, 5) have a bent form in cross-section.

7. Contact element according to one of the preceding claims,
**characterized in that**
the contact arms (3, 4, 5) have a tapering form (6, 7, 8).

8. Contact element according to one of the preceding claims,
**characterized in that**
the fastening region (20) has at least two fastening feet (25, 26) for fastening to the first printed circuit board (30), all contact arms (3, 4, 5) are arranged between the fastening feet (25, 26) in the direction of the longitudinal axis (x) and the fastening feet (25, 26) are located further away from the longitudinal axis (x) in the transverse direction (y) than the contact arms (3, 4, 5) extend in the transverse direction (y).

9. Contacting device,
**characterized by**
a plurality of contact elements (1), which are each formed according to one of the preceding claims, and
an insulating body (50), in which, for each contact element (1), at least one fastening opening (55) is formed in each case, in which the respective contact element (1) is held,
wherein the contact arms (3, 4, 5) project from an upper side of the insulating body (50) and fastening feet (25, 26) of the contact elements (1) project from an underside of the insulating body (50).

10. Contacting device according to the preceding claim, **characterized in that**
the insulating body (50) has at least two upwardly projecting adjusting pins (51) on its upper side,
the adjusting pins (51) are longer than the contact arms (3, 4, 5) and the adjusting pins (51) have a tapering end (52).

11. Printed circuit board arrangement
having at least one contact element (1) according to one of Claims 1 to 8, or having a contacting device according to Claim 9 or 10,
having a first printed circuit board (30), to which the contact element (1) or the contact elements (1) are fastened, and
having a second printed circuit board (40), which, for each contact element (1), has at least one printed circuit board opening (41) for inserting the contact arms (3, 4, 5) of the respective contact element (1).

12. Printed circuit board arrangement according to the preceding claim,
**characterized in that**
a metallic coating (42) is applied to each printed circuit board opening (41).

13. Printed circuit board arrangement according to Claim 11 or 12,
**characterized in that**
a contact socket (45) is mounted at each printed circuit board opening (41), wherein the contact socket (45) has a smaller opening than the printed circuit board opening (41) and the opening of the contact socket (45) is aligned with the printed circuit board opening (41).

14. Printed circuit board arrangement according to one of Claims 11 to 13,
**characterized in that**
the printed circuit board opening (41) or an associated contact socket (45) forms a slot shape in the longitudinal direction (x) of the at least one contact element (1) and
the contact arms (3, 4) contact opposing slot sides.

15. Printed circuit board arrangement according to the preceding claim,
**characterized in that**
a width of the slot-shaped printed circuit board opening (41) is smaller than a width of the contact element (1), which is defined by the contact arms (3, 4, 5), so that, in the assembled state, the contact arms (3, 4, 5) are bent by the slot-shaped printed circuit board opening (41).

16. Printed circuit board arrangement according to one of Claims 11 to 15,
**characterized in that**,
to position fastening feet (25, 26) of the contact element (1) or the contact elements (1) relative to the first printed circuit board (30), each contact element (1) has at least one supporting leg (21, 22) which stands on the first printed circuit board (30) in the assembled state, and
the contact arms (3, 4, 5) are arranged such that they form a gap with respect to the first printed circuit board (30) in the assembled state.

17. Printed circuit board arrangement according to the preceding claim,
**characterized in that**
each contact element (1) has a respective supporting leg (21, 22) between respectively adjacent contact arms (3, 4, 5).

## Revendications

1. Élément de contact destiné à établir un contact électrique entre une première et une deuxième carte de circuit imprimé (30, 40), comportant :
une zone de fixation (20) servant à la fixation à la première carte de circuit imprimé (30) et
une partie fiche (2) destinée à une connexion enfichable à la deuxième carte de circuit imprimé (40),
la partie fiche (2) comportant au moins deux bras de contact (3, 4, 5) qui sont reliés l'un à l'autre de façon électriquement conductrice, **caractérisé en ce que**
l'élément de contact comporte un troisième bras de contact (5), le deuxième bras de contact (4) se trouvant le long de l'axe longitudinal (x) entre les premier et troisième bras de contact (3, 5), et les premier et troisième bras de contact (3, 5) dépassant tous deux de l'axe longitudinal (x) dans la direction transversale (y), tandis que le deuxième bras de contact (4) dépasse de l'axe longitudinal (x) dans la direction transversale (y) en direction opposée (-y).

2. Élément de contact selon la revendication précédente,
**caractérisé en ce que**
tous les bras de contact (3, 4, 5) sont reliés les uns aux autres de façon électriquement conductrice, de sorte qu'ils présentent le même potentiel électrique et forment un contact unique.

3. Élément de contact selon l'une quelconque des revendications précédentes,
**caractérisé en ce que**
l'élément de contact est formé d'un seul tenant.

4. Élément de contact selon la revendication précédente,
**caractérisé en ce que**
l'élément de contact présente une forme allongée le long d'un axe longitudinal (x), les bras de contact (3, 4, 5) s'étendant dans une direction de hauteur (z) perpendiculaire à l'axe longitudinal (x), et la direction transversale (y) étant perpendiculaire à l'axe longitudinal (x).

5. Élément de contact selon l'une quelconque des revendications précédentes,
**caractérisé en ce que**
les bras de contact (3, 4, 5) sont espacés les uns des autres le long de l'axe longitudinal (x).

6. Élément de contact selon l'une quelconque des revendications précédentes,
**caractérisé en ce que**
les bras de contact (3, 4, 5) présentent une forme incurvée en section transversale.

7. Élément de contact selon l'une quelconque des revendications précédentes,
**caractérisé en ce que**
les bras de contact (3, 4, 5) présentent une forme conique (6, 7, 8).

8. Élément de contact selon l'une quelconque des revendications précédentes,
**caractérisé en ce que**
la zone de fixation (20) comporte au moins deux pieds de fixation (25, 26) servant à la fixation à la première carte de circuit imprimé (30), l'ensemble des bras de contact (3, 4, 5) sont agencés entre les pieds de fixation (25, 26) dans la direction de l'axe longitudinal (x), et les pieds de fixation (25, 26) sont situés de manière à plus grande distance de l'axe longitudinal (x) dans la direction transversale (y) que ne s'étendent les bras de contact (3, 4, 5) dans la direction transversale (y).

9. Dispositif de contact,
**caractérisé par**
plusieurs éléments de contact (1), qui sont respectivement réalisés selon l'une quelconque des revendications précédentes, et
un corps isolant (50) dans lequel est respectivement formée pour chaque élément de contact (1), au moins une ouverture de fixation (55) dans laquelle l'élément de contact (1) respectif est maintenu,
les bras de contact (3, 4, 5) faisant saillie par rapport à une face supérieure du corps isolant (50) et les pieds de fixation (25, 26) des éléments de contact (1) faisant saillie par rapport à une face inférieure du corps isolant (50).

10. Dispositif de contact selon la revendication précédente,
**caractérisé en ce que**
le corps isolant (50) comporte sur sa face supérieure au moins deux broches de centrage saillantes (51) ;
les broches de centrage (51) sont plus longues que les bras de contact (3, 4, 5) et les broches de centrage (51) présentent une extrémité conique (52).

11. Agencement de cartes de circuit imprimé
comprenant au moins un élément de contact (1) selon l'une quelconque des revendications 1 à 8 ou comprenant un dispositif de contact selon la revendication 9 ou 10, comprenant une première carte de circuit imprimé (30) à laquelle sont fixés l'élément de contact (1) ou les éléments de contact (1), et
comprenant une deuxième carte de circuit imprimé (40) qui comporte, par élément de contact (1), au moins une ouverture de carte de circuit imprimé (41) pour l'insertion des bras de contact (3, 4, 5) de l'élément de contact (1) respectif.

12. Agencement de cartes de circuit imprimé selon la revendication précédente,
**caractérisé en ce que**
un revêtement métallique (42) est appliqué à chaque ouverture de carte de circuit imprimé (41).

13. Agencement de cartes de circuit imprimé selon la revendication 11 ou 12,
**caractérisé en ce que**
une douille de contact (45) est fixée à chaque ouverture de carte de circuit imprimé (41), la douille de contact (45) présentant une ouverture plus petite que l'ouverture de carte de circuit imprimé (41) et l'ouverture de la douille de contact (45) étant alignée avec l'ouverture de carte de circuit imprimé (41).

14. Agencement de cartes de circuit imprimé selon l'une quelconque des revendications 11 à 13,
**caractérisé en ce que**
l'ouverture de carte de circuit imprimé (41) ou une douille de contact (45) associée définit une forme de fente dans la direction longitudinale (x) dudit au moins un élément de contact (1), et
les bras de contact (3, 4) sont en contact avec des côtés opposés de la fente.

15. Agencement de cartes de circuit imprimé selon la revendication précédente,
**caractérisé en ce que**
une largeur de l'ouverture de carte de circuit imprimé en forme de fente (41) est plus petite qu'une largeur de l'élément de contact (1) définie par les bras de contact (3, 4, 5), de telle sorte qu'à l'état monté, les bras de contact (3, 4, 5) sont courbés par l'ouverture de carte de circuit imprimé en forme de fente (41).

16. Agencement de cartes de circuit imprimé selon l'une quelconque des revendications 11 à 15,
**caractérisé en ce que**
pour le positionnement des pieds de fixation (25, 26) de l'élément de contact (1) ou des éléments de contact (1) par rapport à la première carte de circuit imprimé (30), chaque élément de contact (1) comporte au moins un pied de support (21, 22) qui repose sur la première carte de circuit imprimé (30) à l'état monté ; et
les bras de contact (3, 4, 5) sont agencés de manière à former un interstice par rapport à la première carte de circuit imprimé (30) à l'état monté.

17. Agencement de cartes de circuit imprimé selon la revendication précédente,
**caractérisé en ce que**
chaque élément de contact (1) comporte un pied de support (21, 22) entre des bras de contact (3, 4, 5) adjacents.
